# EUROPEAN PATENT APPLICATION

(11) **EP 0 661 914 A2**
(43) Date of publication of application: **05.07.1995**
(21) Application number: 94309183.5
(22) Date of filing: 09.12.1994
(51) Int. Cl.: H05K 3/00, H05K 13/00, H05K 3/34

(54) **Board center registration for solder paste deposition**

(30) Priority: 30.12.1993 US 175913
(71) Applicant: AT&T Corp., New York, NY 10013-2412 (US)
(72) Inventor: Ammann, Hans Hugo, Chester, New Jersey 07930 (US); Vasco, Francis Lo, Succasunna, New Jersey 07876 (US); Oien, Michael Ackman, Chatham, New Jersey 07928 (US)
(74) Representative: Johnston, Kenneth Graham

(57) **Abstract**

To produce registration of a printed circuit board with a stencil for solder paste deposition, movable pins first engage the stencil, are locked into place, the stencil removed, the printed circuit board engaged to the pins, and the stencil returned to the engagement with the pins. Mounting the pins modularly allows different size printed circuit boards and stencils to register with each other.

## Description

### FIELD OF THE INVENTION

This invention relates to deposition of solder paste through stencil openings onto printed circuit (PC) boards, and particularly to producing registration of stencil openings to the structures on the PC boards.

### BACKGROUND OF THE INVENTION

Printing solder paste onto PC boards requires accurate alignment between stencil openings and structures on the PC board. such registration currently involves manually looking through the stencil openings at the features on the PC board and adjusting the position of the stencil. This offers only limited precision. Board center registration (BCR), or panel center registration, for PC board manufacture may entail positioning comparatively light artwork over PC boards. However stencil printing uses relatively heavy stencils and frames. These do not lend themselves to easy movement. Excessive forces on the rather fragile stencil tend to damage it.

An object of the invention is to avoid these difficulties.

Another object of the invention is to improve center board registration (BCR).

### SUMMARY OF THE INVENTION

According to an aspect of the invention, such objects are attained by moving board center registration pins along a plane until they engage stencil tooling holes which cause the pins to align themselves with the stencil, fixing the pins in place, engaging openings in a PC board with the pins, prior to solder paste deposition.

According to another feature of the invention, the pins are affixed to modularly mounted movable blocks.

For other stencils, the stencil, the pins can be unlocked and realigned to other stencil positions and prefixed prior to mounting of the PC boards and solder paste deposition.

According to another feature of the invention, the tooling pins are asymmetrically aligned relative to each other to prevent reverse positioning of the PC boards.

These and other features of the invention are pointed out in the claims. Other objects and advantages of the invention will become evident from the following detailed description when read in light of the accompanying drawings.

### BRIEF DESCRIPTION OF THE DRAWINGS

Fig. 1 is perspective plan view of a board center registration tooling embodying features of the invention.

Fig. 2 is a section 2-2 through the tooling of Fig. 1.

Fig. 3 is a perspective view showing alignment of the stencil and PC board with the apparatus in Figs. 1 and 2.

Fig. 4 is a schematic diagram showing a movement mechanism in the apparatus of Figs. 1 to 3.

Fig. 5 is a schematic diagram showing alternate placement of pins in the arrangement of Figs. 1 to 4.

### DETAILED DESCRIPTION OF PREFERRED EMBODIMENTS

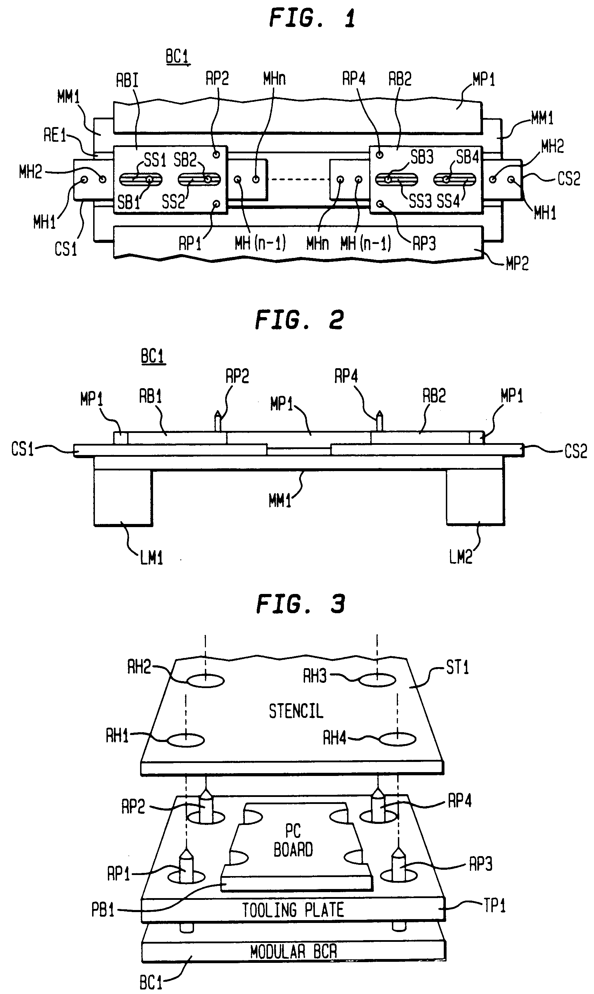

Figs. 1 to 5 show details on use of a modular board center registration tooling (BCR) BC1. In the BCR BC1 Figs. 1, 2, and 3, a mounting plate MM1 defines a recess RE1 which carries two carrier slides CS1 and CS2 each having a series of tapped mounting holes MH1 to MHn. Two modular registration blocks RB1 and RB2 define stepped slots SS1 to SS4 through which securing bolts SB1 to SB4 fasten the blocks to selected mounting holes MH1 to MHn in the carrier slides CS1 and CS2. Two spaced registration pins RP1 and RP2 extend vertically upward from the block RB1, and two registration pins RP3 and RP4 extend vertically upward from the block RB2.

Selection of the holes MH1 to MHn in which the bolts SB1 to SB4 fasten the blocks RB1 and RB2, and the position of the bolts SB1 to SB4 along the slots SS1 to SS4, allows the pairs of pins RP1, RP2 and RP3, RP4 to occupy any desired lateral positions along the recess RE1. Locking members LM1 and LM2 secured by bolts or otherwise allow slack for movement of the carrier slides CS1 and CS2 horizontally transverse to and within the recess RE1 while unlocked. They also allow the carrier slides CS1 and CS2, and registration blocks RB1 and RB2 and their pins RP1 to RP4, to move laterally with the slides along the recess RE1 over a short limited range. When a desired position for the pins RP1 to RP4 is achieved, the locking members LM1 and LM2 are manually locked to secure the blocks RB1 and RB2, and hence the pins RP1 to RP4, in that position.

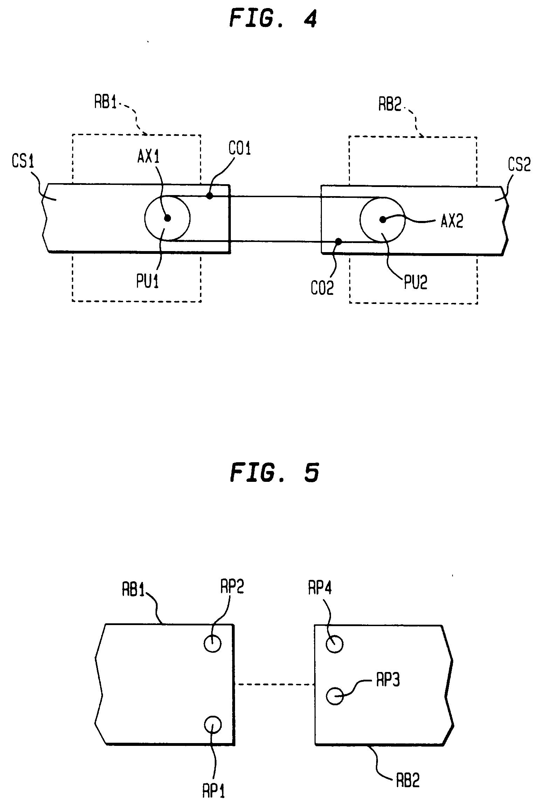

An interlink IL1, shown only schematically as a broken line in Fig. 1, causes outward movement of carrier slide CS1, and one block RB1 and its pins RP1 and RP2, to result in limited reciprocal outward movement of the other carrier slide CS2, and its block RB2 and its pins RP3 and RP4. Similarly, the interlink IL1 causes inward movement of the slide CS1, and one block RB1 and its pins RP1 and RP2, to produce inward movement of the other slide CS2, and block RB1 and its pins RP3 and RP4. Details of the interlink appear in Fig. 4.

Fig. 3 is an exploded view showing the pins RP1 to RP4 of the BCR BE1 aligning with openings OP1 to OP4 in a tooling plate TP1, with registration cuts RC1 to RC4 in a PC board PB1, and with registration holes RH1 to RH4 in a stencil ST1. Prior to assembling the apparatus in Fig. 3, the stencil ST1 is placed over the modular BCR BC1 so that the movable pins RP1 to RP4 register with the holes RH1 to RH4. The registration holes RH1 to RH4 thus establish the distances from the pins RP1 and RP2 to the pins RP3 and RP4. The locking members LM1 and LM2 lock the pins in place and only then are the members assembled as shown in Fig. 3.

Fig. 4 schematically illustrates the interlink IL1 of Fig. 1 and its operation. Here, two pulleys PU1 and PU2 have axles AX1 and AX2 mounted on the mounting member MM1. An endless wire band WB1 passes around the pulleys PU1 and PU2 and is coupled to the slides CS1 and CS2 at respective connecting points CO1 and CO2. When the slide CS1 is moved outwardly, i.e. to the left in Fig. 4, it draws the portion of the wire band at the connecting point CO1 outwardly to the left and around the pulleys PU1 and PU2. This causes the connecting point CO2 on the band WB1 to move outwardly to the right and thereby pull the slide CS2 outwardly to the right. Conversely, when the slide CS1 is moved inwardly, i.e. to the right in Fig. 4, it draws the portion of the wire band WB1 at the connecting point CO1 inwardly to the right and around the pulleys PU1 and PU2. This causes the band WB1 to move inwardly to the left at the connecting point CO2 and thereby pull the slide CS2 inwardly to the left. Movement of the slide CS2 causes corresponding opposing movement of the slide CS1. The slides CS1 and CS2 carry the blocks RB1 and RB2 and their registration pins RP1 to RP4.

Suitable means (not shown), on the locking members LM1 and LM2 or elsewhere, limit movement of the slides RP1 and RP2 over small distances sufficient to allow the pins RP1 to RP4 on the blocks RB1 and RB2 to achieve a desired position of registration with the registration holes RH1 to RH4 of the stencil ST1 and the cuts RC1 to RC4 on the PC boards. The motions of slides RP1 and RP2 must be small enough to prevent the connecting points CO1 and CO2 to reach the peripheries of the pulleys PU1 and PU1.

According to an embodiment of the invention, the distances between the pins RP1 and RP2 and between the pins RP3 and RP4 are different to prevent inadvertent registration of a PC board or a stencil which is placed upside down. Fig. 5 illustrates such pins. The registration holes RH1 to RH4 and the registration cuts RC1 to RC4 are arranged so that distances between them correspond to the distances between the pins RP1 and RP2 and between the pins RP3 and RP4.

The blocks RB1 and RB2 constitute modular mountings for the pins RP1 to RP4. They are removable from the carrier slides RP1 and RP2 and allow placement over a number of mounting holes MH1 to MHn, and infinitesimally movable along the slots SS2 to SS4. The pins are then further movable in the unlocked position of the locking members LM1 and LM2. This then represents modular positioning of the pins RP1 to RP4.

In the most general form, the operation of the system in Figs. 1 to 4 begins with the blocks RB1 and RB2 removed from the carrier slides CS1 and CS2. An operator then determines the approximate distance needed between the pins RP1, RP2 and RP3, RP4. The operator then bolts the blocks RB1 and RB2 with securing bolts SB1 to SB4 through the stepped slots SS1 and SS2 at the appropriate mounting holes MH1 to MHn and at the approximate desired position relative to the registration holes RH1 to RH4 on the stencil ST1. The proper spacing may be selected by comparison with the holes RH1 and RH2 on the stencil ST1. At this point the locking members LM1 and LM2 are unlocked or have been unlocked.

The operator then places the stencil ST1 along the mounting plates MP1 and MP2 and moves the slides CS1 and CS2 over a limited range until the blocks RB1 and RB2 move the pins RP1 to RP4 into registration with the holes RH1 to RH4. When the pins RP1 to RP4 engage the holes RH1 to RH4, the locking members LM1 and LM2 are locked by the operator to fix the positions of the slides SC1 and SC2 as well as the blocks RB1 and RB2, and therefore the pins RP1 to RP4. The operator then removes the stencil ST1 and places the tooling plate TP1 and the PC board on the mounting plates MP1 and MP2 so that the registration cuts RC1 to RC4 engage the pins RP1 to RP4. The operator then replaces the stencil ST1 over the PC board PB1 so that the registration holes RH1 to RH4 engage the pins RP1 to RP4. Solder paste is then placed on the PC board through the stencil. The solder paste is then processed in the usual manner.

According to an embodiment of the invention, the registration process of placing the stencil and removing the stencil, of placing the tooling plate, the PC board and the stencil utilizes a machine operation.

Different forms of interlinks are feasible. For example, two arms connected to the respective slides and coupled to respective ends of a center-pivoted lever between the slides will achieve the same result.

In one embodiment, the tooling plate TP1 is omitted.

While embodiments of the invention have been described in detail, it will be evident to those skilled in the art that the invention may be embodied otherwise without departing from its spirit and scope.

## Claims

1. A registration method for processing printed circuit (PC) boards, comprising:
engaging a plurality of movable pins with corresponding holes in a stencil;
disengaging the stencil from the pins;
placing a printed circuit board having registration means so said registration means engage said pins;
engaging the holes of the stencil with said printed circuit board; and
processing the printed circuit board.

2. The method as in claim 1, wherein said pins are mounted on movable blocks.

3. The method as in claim 1, wherein the step of moving the pins includes moving opposing pins in opposite directions simultaneously.

4. An apparatus for processing printed circuit boards using stencils, comprising:
a pair of modular mounted blocks movable relative to each other;
linking means for linking the blocks so that movement of one causes movement of the other in an opposing direction;
locking means for locking the blocks;
said blocks having registration pins for alignment of stencil holes with the pins such that the pins travel in a range on the blocks for engaging the stencil holes.

5. An apparatus as in claim 4, wherein the pins are mounted on the blocks asymmetrically so that the pins avoid engagement with reverse sides of a printed circuit board or a stencil.
